# FASCICULE DE BREVET EUROPEEN

(11) **EP 2 842 170 B1**
(45) Date de publication et mention de la délivrance du brevet: **07.03.2018**
(21) Numéro de dépôt: 13722479.6
(22) Date de dépôt: 09.04.2013
(51) Int. Cl.: H01L 31/0236, H01L 31/0224, H01L 31/056, G02B 5/08, G02B 5/09

(54) **PROCÉDÉ DE RÉALISATION D'UN RÉFLECTEUR TEXTURÉ POUR UNE CELLULE PHOTOVOLTAÏQUE EN COUCHES MINCES ET RÉFLECTEUR TEXTURÉ AINSI OBTENU**
VERFAHREN ZUR HERSTELLUNG EINES STRUKTURIERTEN REFLEKTORS FÜR EINE PHOTOVOLTAISCHE DÜNNSCHICHTZELLE UND ENTSPRECHENDER STRUKTURIERTER REFLEKTOR
METHOD FOR PRODUCING A TEXTURED REFLECTOR FOR A THIN-FILM PHOTOVOLTAIC CELL, AND RESULTING TEXTURED REFLECTOR

(30) Priorité: 27.04.2012 FR 1201248
(43) Date de publication de la demande: 04.03.2015
(73) Titulaire: Commissariat à l'Énergie Atomique et aux Énergies Alternatives, 75015 Paris (FR)
(72) Inventeur: DUCROS, Cédric, FR-38690 Bevenais (FR); SZAMBOLICS, Helga, FR-38000 Grenoble (FR)
(74) Mandataire: Talbot, Alexandre
(86) Numéro de dépôt international: PCT/FR2013/000093
(87) Numéro de publication internationale: WO 2013/160570

(56) Documents cités:
- EP-A2- 0 698 929
- EP-A2- 1 921 668
- WO-A1-2008/035818
- KR-A- 20090 087 529
- US-A1- 2011 005 575
- Brian Wellington Lewis: "Silica Nanosphere Textured Back Reflectors for Increased Absorption in Thin Film Amorphous Silicon Solar Cells", , 4 mai 2010 (2010-05-04), XP055046962, Extrait de l'Internet: URL:http://archives.ece.iastate.edu/archiv e/00000550/01/Thesis_Final.pdf [extrait le 2012-12-06]
- KOSIOREK A ET AL: "Fabrication of nanoscale rings, dots, and rods by combining shadow nanosphere lithography and annealed polystyrene nanosphere masks", SMALL, WILEY - VCH VERLAG GMBH & CO. KGAA, DE, vol. 1, no. 4, 25 février 2005 (2005-02-25), pages 439-444, XP002664106, ISSN: 1613-6810, DOI: 10.1002/SMLL.200400099 [extrait le 2005-02-25]

## Description

### Domaine technique de l'invention

L'invention est relative à un procédé de réalisation d'un réflecteur texturé pour une cellule photovoltaïque en couches minces et elle est également relative à un réflecteur texturé ainsi obtenu.

### État de la technique

Une cellule photovoltaïque en couches minces, également connue sous le nom anglo-saxon de « thin film solar cell » ou « thin film photovoltaic cell », comprend classiquement au moins un substrat (ou support), sur lequel est déposée au moins une couche mince en matériau photovoltaïque, aussi appelée couche active ou couche absorbante. Elle comporte aussi classiquement une électrode et des contacts électriques.

Il existe différentes catégories de cellules photovoltaïques en couches minces selon le type de matériau photovoltaïque utilisé. Celui-ci peut être par exemple du silicium amorphe (a-Si) ou bien il peut s'agir d'un bicouche silicium amorphe hydrogéné a-Si :H / silicium microcristallin µc-Si :H...

Actuellement, un des principaux enjeux dans le domaine des cellules photovoltaïques en couches minces est d'augmenter le rendement de conversion photovoltaïque, en augmentant l'efficacité du piégeage optique du rayonnement électromagnétique incident au sein de la cellule photovoltaïque, grâce à un réflecteur texturé disposé entre le substrat et la couche active.
Par exemple, la demande de brevet US 2011/0005575 décrit l'utilisation d'un réflecteur présentant une texturation, sous forme de vague, dans une cellule photovoltaïque, pour augmenter notamment le piégeage optique de la lumière, la réflectivité et le rendement de conversion. Les couches minces déposées sur le réflecteur sont alors également texturées.

La forme et l'amplitude de la texturation du réflecteur déterminent en particulier la gamme de longueur d'onde dans laquelle le piégeage optique est efficace. Ainsi, les caractéristiques de la texturation du réflecteur permettent de modifier de manière conséquente la réponse optique de la cellule photovoltaïque. Il est donc nécessaire d'élaborer des procédés fiables, robustes, reproductibles et faciles à mettre en oeuvre afin d'obtenir un réflecteur texturé présentant des performances optiques optimales.

L'article de Zhu et al. « Nanodome Solar Cells with Efficient Light Management and Self-Cleaning » (Nanoletters 2010, 10, 1974-1984) propose de texturer le substrat, en verre ou en quartz, pour former une cellule photovoltaïque présentant une texturation en forme de nano-dômes (« nanodomes solar cells »). Pour réaliser cette texturation, des billes de silice sont, dans un premier temps, déposées sur le substrat. Puis le substrat est gravé, à travers le lit de billes, par gravure ionique réactive sous un mélange O₂/CHF₃. Finalement une structure multicouche est déposée sur le substrat texturé.
Cependant, cette technique présente plusieurs inconvénients : des contaminations peuvent provenir des espèces du plasma, la vitesse de gravure est relativement lente, le procédé d'élaboration est assez lourd à mettre en place en matière de temps et de coût et surtout ce procédé ne peut s'appliquer que sur des substrats pouvant être facilement gravés, tels que le verre et le quartz.

Un autre procédé de réalisation pouvant être mis en place pour réaliser une surface texturée est décrit dans l'article de Hitoshi Sai (Journal of Applied Physics 2009, 105, 094511). En particulier, l'anodisation d'un substrat en aluminium sous une forte tension est réalisée. La tension appliquée provoque la formation d'une couche d'oxyde poreux en Al₂O₃ à la surface du substrat. En même temps, la surface du substrat en aluminium se modifie et elle prend une texturation en forme de vagues. Après l'anodisation, la couche d'oxyde est retirée et un substrat texturé en aluminium est ainsi obtenu.
Une telle technique nécessite, cependant, de fortes tensions d'anodisation et il est difficile de contrôler la texturation et la périodicité des motifs obtenus. De plus, le choix du substrat est particulièrement réduit. Un procédé de fabrication d'un réflecteur pour une cellule photovoltaïque est également connu du document "Silica Nanosphere Textured Back Reflectors for Increased Absorption in Thin Film Amorphous Silicon Solar Cells", Brian Wellington Lewis (thèse, lowa State University, 2010).

Le document EP 1 921 668 A2 divulgue un procédé de fabrication d'une couche semi-conductrice sur une couche métallique. La couche métallique forme également un réflecteur pour une diode électroluminescente formée sur cette couche métallique. La couche semi-conductrice active est déposée sur la couche métallique comprenant des ouvertures pour faciliter une croissance. Les billes d'une taille nanométrique sont employées pour fabriquer des ouvertures dans la couche métallique.

### Objet de l'invention

L'invention a pour but de remédier aux inconvénients de l'art antérieur et, en particulier, de proposer un procédé d'élaboration d'un réflecteur texturé pour une cellule photovoltaïque en couches minces, simple et facile à mettre en oeuvre, robuste, reproductible et peu coûteux.

On tend vers cet objet par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 4 illustrent, de manière schématique et en coupe, différentes étapes de réalisation d'un réflecteur texturé pour une cellule photovoltaïque en couches minces,
- la figure 5 illustre, de manière schématique et en coupe, une cellule photovoltaïque en couches minces comprenant le réflecteur texturé selon la figure 4,
- la figure 6 représente un cliché obtenu par microscopie électronique à balayage, lors d'une étape du procédé d'élaboration d'un réflecteur texturé selon l'invention,
- la figure 7 représente un cliché obtenu par microscopie électronique à balayage, sur une cellule photovoltaïque selon l'invention,
- la figure 8 représente la simulation de la puissance absorbée dans une cellule photovoltaïque petit gap (aSiGe) en fonction du diamètre des billes constituant le masque pour une cellule photovoltaïque comprenant un réflecteur texturé réalisé selon l'invention, et pour une cellule photovoltaïque avec un réflecteur non texturé,
- la figure 9 représente l'évolution du facteur de Haze en fonction de la longueur d'onde pour une cellule photovoltaïque avec un réflecteur texturé selon l'invention et pour une cellule photovoltaïque avec un réflecteur non texturé,
- la figure 10 représente la courbe I(V) de la cellule : la densité de courant de court-circuit en fonction de la tension d'une cellule photovoltaïque avec un réflecteur texturé selon l'invention et d'une cellule photovoltaïque avec un réflecteur non texturé.

### Description d'un mode de réalisation préférentiel de l'invention

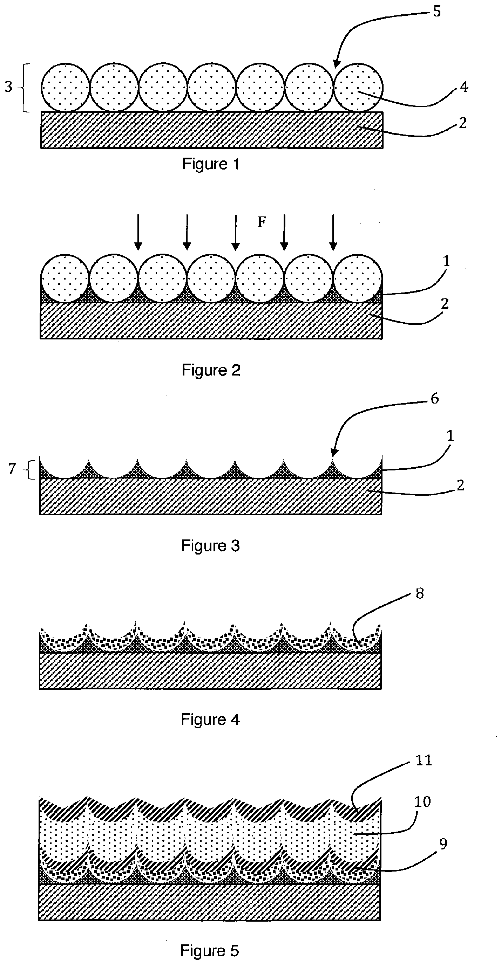

Comme illustré aux figures 1 à 4, un procédé de réalisation d'un réflecteur texturé pour une cellule photovoltaïque, et plus particulièrement pour une cellule photovoltaïque en couches minces, comporte, au moins, le dépôt d'un film métallique 1 sur un support 2, de préférence plan ou non texturé, à travers les ouvertures d'un masque 3 particulier. Le support 2 est de préférence en métal.

Le masque 3 utilisé pour réaliser le dépôt du film métallique 1 est, en effet, formé par une première couche également appelée couche mince constituée de billes 4 coplanaires.

Par couche mince, on entend avantageusement une couche d'une épaisseur comprise entre 300nm et 1500nm. L'épaisseur est inférieure au rayon de la sphère.
Avantageusement, le masque 3 est constitué par ladite couche mince. Préférentiellement, les billes 4 forment une seule et unique couche mince. Elles sont disposées de manière à former un lit de billes sur le support, chaque bille 4 étant en contact direct avec ledit support 2. Dans ce cas, elle ne sont donc pas empilées les unes sur les autres.
De plus, les billes 4 constituant la couche mince sont, de préférence, jointives. La couche mince ainsi formée est alors homogène et régulière, avec des interstices 5 entre les billes 4 formant les ouvertures du masque 3, à travers lesquelles est déposé le métal destiné à former le film métallique 1.

Les billes 4 étant préférentiellement de forme sphérique, les interstices 5 entre les billes sont alors tous identiques.
Les billes 4 sont, avantageusement, en silice, en métal, en céramique ou en polymère, ce qui permet notamment d'élaborer un masque à bas coût. Par exemple, elles peuvent être en polystyrène ou encore en aluminium, titane, chrome ou or.

De préférence, le diamètre moyen des billes 4 est compris entre 100nm et 5000nm, et avantageusement entre 500nm et 2500nm.
Les billes 4 constituant la couche mince sont, par ailleurs, avantageusement, monodisperses, c'est-à-dire des billes morphologiquement identiques, dont la distribution de taille est très étroite, centrée autour d'un diamètre moyen particulier, avec un écart-type de plus ou moins 10%.
Ainsi, pour un masque 3 donné, les billes 4 ont toutes, avantageusement, un même diamètre moyen.
Enfin, la couche mince formant le masque 3, présente, avantageusement, une compacité comprise entre 80% et 94%. La compacité, aussi appelée taux de remplissage, est le rapport du volume total des billes 4 constituant la couche mince sur celui du volume total de la couche mince qui les contient. Une telle plage de valeur pour la compacité représente un bon compromis par rapport à la taille des interstices utilisés pour le dépôt du film métallique.

Comme illustré sur la figure 1, le masque 3 est, par exemple, réalisé sur le support par dépôt à la tournette, aussi nommé spin-coating en anglais, ou encore par la méthode de Langmuir-Blodgett.
De telles techniques de dépôts de billes sont très compétitives en termes de coût et applicable aux grandes surfaces. Elles permettent, de plus, d'être compatibles avec un large choix de supports comme, par exemple, un support en métal, en silicium, en verre ou en polymère.

Selon un mode de réalisation particulier, la formation du masque 3 peut comporter une étape de gravure des billes 4 préalablement formées sur le support 2, afin de réduire leur diamètre moyen initial. L'étape de gravure permet de réduire la taille initiale des billes 4 et donc d'augmenter le volume des interstices 5.
L'étape de gravure peut être réalisée par attaque chimique ou gravure sèche (reactive ion etching en anglais).

Ensuite, le film métallique 1 est déposé à travers les ouvertures du masque 3, c'est-à-dire entre les interstices 5 des billes 4, comme illustré sur la figure 2. Une telle étape de dépôt est schématisée sur la figure 2 par les flèches F disposées au-dessus du masque 3. Le film métallique 1 ainsi déposé est composé d'une pluralité de plots 6, chaque plot occupant l'interstice ou l'espace libre entre les billes jointives, et avantageusement entre trois billes jointives, ce qui permet d'obtenir la texturation du film métallique 1. Par exemple, pour un masque 3 comportant des billes 4 avec un diamètre moyen compris dans la plage entre 300nm et 1500nm, des plots 6 d'une hauteur comprise entre 150 et 750nm sont obtenus.
Les plots peuvent être séparés les un des autres, comme représenté sur la figure 3. Les plots peuvent comporter au moins trois ou quatre faces selon l'arrangement des billes. Chaque face présente une forme complémentaire des billes, c'est-à-dire une forme en arc de cercle. Les plots peuvent aussi être reliés les uns aux autres au niveau du support de manière à former une structure en nid d'abeille.

Avantageusement, le dépôt du film métallique 1 est réalisé par pulvérisation cathodique magnétron ou par évaporation sous vide. Ces technologies permettent de ne pas détériorer les billes 4 et de déposer une couche uniforme, à travers le masque 3, au niveau des interstices 5 entre les billes 4.
De plus, la formation du masque 3 étant bien maîtrisée, l'espacement et la période des plots 6 métalliques sont parfaitement contrôlés, de manière précise et reproductible. Par ailleurs, en faisant varier la taille des billes 4 et la compacité du masque 3, les caractéristiques du film métallique 1 sont facilement modifiables.
Lorsque les billes 4 sont monodisperses, l'espacement entre les plots 6 est constant. Dans ce cas, les plots 6 seront espacés, au maximum, par une distance équivalente à celle du diamètre moyen des billes 4, c'est-à-dire entre 300nm et 1500nm pour des billes de 300 à 1500nm de diamètre, ce qui correspond à la gamme de longueur d'onde visée dans le domaine photovoltaïque. La texturation du film métallique 1 et la périodicité de l'espacement des plots 6 sont donc contrôlées et l'efficacité du piégeage optique du rayonnement électromagnétique incident est ainsi améliorée.

Préférentiellement, le film métallique 1, déposé à travers le masque 3, est un film constitué par un métal choisi parmi l'aluminium, le chrome, l'argent et le cuivre. Il peut aussi être constitué par un alliage d'un ou plusieurs des métaux précités.
L'épaisseur maximale 7 du film métallique 1 est, avantageusement, comprise entre 150nm et 750nm et elle correspond à la hauteur maximale des plots 6 formés dans les interstices 5 des billes 4. La hauteur des plots 6 est donc contrôlée à la fois par la quantité de métal déposée lors de la formation du film métallique 1 et par la taille des billes 4. Un facteur de forme des plots, correspondant à la hauteur de plot sur la dimension de la base du plot, plus ou moins prononcé peut ainsi être obtenu.
Le facteur de forme des plots 6 peut donc aussi être modifié en gravant les billes 4 avant le dépôt du film métallique 1.
L'aspect géométrique de la texturation est ainsi aisément contrôlé.

Après l'étape de dépôt du film métallique 1 sur le support 2, le masque 3 est retiré comme illustré sur la figure 3. Une des techniques utilisées pour le retrait du masque est, par exemple, un passage dans un bain d'éthanol aux ultra-sons pendant 5 minutes.
De plus, pour ne pas détériorer les plots 6 lors du retrait du masque 3, les plots 6 métalliques, formant le film métallique 1, ont, de préférence, une hauteur maximale inférieure au rayon des billes 4.
Dans certains cas qui ne font pas partie de l'aspect inventif de l'invention le film métallique 1 ainsi texturé constitue le réflecteur. Le réflecteur texturé est, en particulier, constitué par les plots 6 métalliques. Ces derniers peuvent avantageusement être à base d'argent pour d'obtenir un réflecteur ayant de bonnes propriétés optiques et électriques. Selon le procédé de l'invention le film métallique 1 est associé à, au moins, un autre film métallique comme illustré sur la figure 4.
Ainsi, après le retrait du masque 3, un dépôt uniforme d'un film métallique additionnel 8 est réalisé sur le film métallique 1. Le film additionnel 8 est déposé, par exemple, par dépôt physique en phase vapeur ou dépôt chimique en phase vapeur. Ces technologies permettent de déposer un film uniforme.
Par dépôt uniforme, on entend que l'épaisseur du film additionnel 8 déposée est sensiblement la même en tout point de la surface. Ainsi, comme il est déposé sur le film métallique 1 texturé, il présente également une surface texturée. Le film additionnel 8 a une épaisseur, de préférence, comprise entre 50nm et 1500nm et, plus particulièrement, entre 100nm et 500nm.
Le film additionnel 8 est constitué par un film en métal choisi parmi l'argent, l'aluminium, le cuivre, le chrome et le titane ou un de leurs alliages, c'est-à-dire un alliage d'un ou plusieurs métaux précités. Plus particulièrement, l'argent peut être choisi pour ces bonnes propriétés optiques, il s'agit d'un excellent réflecteur, et pour ses propriétés électriques, notamment en terme de conductivité. Une bonne conductivité permet, par exemple, d'évacuer les charges générées par la cellule photovoltaïque.
Le film additionnel 8 est avantageusement constitué par un matériau métallique distinct de celui constituant le film métallique 1.
Tout autre métal décrit précédemment peut être utilisé pour réaliser le film métallique 1. Il peut s'agir d'un métal peu cher et présentant de faibles propriétés optiques. En effet, les plots 6 étant recouverts par le film additionnel 8, seul ce dernier film peut présenter de bonnes propriétés optiques pour les applications visées. Cette combinaison de deux films métalliques 1 et 8 permet notamment de diminuer les coûts d'élaboration.

Selon un mode de réalisation préférentiel, le film métallique 1 est en aluminium et le film additionnel 8 est en argent. Ces deux films superposés forment alors un réflecteur texturé convenant à la réalisation d'une cellule photovoltaïque en couches minces.

Avantageusement, une ou plusieurs couches pourraient être interposées entre le support 2 et le réflecteur texturé, par exemple pour améliorer la planéité du support 2.

Selon les modes de réalisation décrits précédemment, le procédé de réalisation du réflecteur texturé ainsi formé peut être complété par d'autres opérations pour former une cellule photovoltaïque en couches minces. Les derniers composants peuvent donc être déposés, une fois le réflecteur texturé réalisé pour former la cellule photovoltaïque. Un exemple de cellule photovoltaïque est ainsi représenté sur la figure 5. La cellule comporte :
- un support 2, par exemple en métal, en silicium, en verre ou en polymère,
- un réflecteur texturé tel que représenté sur la figure 4,
- une première couche 9, en oxyde transparent conducteur, également connu sous le nom anglo-saxon « transparent conducting oxide » ou TCO,
- une couche absorbante 10,
- une seconde couche d'oxyde transparent conducteur 11,
- et des contacts électriques.
L'oxyde transparent conducteur est par exemple choisi parmi ITO, SnO2:F, ZnO:Al, ZnO:B, ZnO:Ga, IZO, IOH.

Un test comparatif a été réalisé pour déterminer le diamètre optimal des billes 4 du masque 3 servant à l'élaboration d'un réflecteur texturé particulier. Dans cet exemple, il s'agit d'obtenir un maximum d'absorption pour une cellule photovoltaïque en couches minces dont la couche absorbante a un gap d'environ 1,4eV. La couche absorbante 10 utilisée pour la réalisation de la cellule photovoltaïque est en aSiGe :H et les couches d'oxyde transparent conducteur 9 et 11 sont en AZO (ZnO:Al).

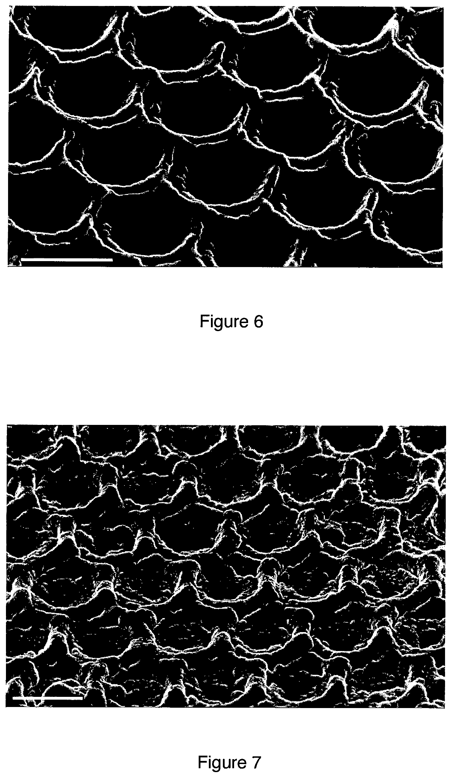

Le support 2 est en verre et les billes 4 formant le masque sont en silice. Quatre masques 3 ont été réalisés avec des billes 4 en silice, ayant un diamètre moyen, respectivement, de 500nm, 1000nm, 1500nm et 2000nm.
Un film 1 en aluminium de 500nm d'épaisseur est ensuite déposé par évaporation, à travers les ouvertures de chacun des masques. Après le retrait de chacun des masques 3 par ultra-sons, des plots métalliques 6 bien définis et régulièrement espacés sont obtenus. A titre d'exemple, la figure 6 illustre le film 1 obtenu avec un masque 3 composé de billes 4 de 1000nm de diamètre. Puis le dépôt d'un film additionnel 8 en argent de 200nm d'épaisseur est réalisé sur chacun des films métalliques précédemment réalisés par pulvérisation cathodique magnétron. La figure 7 représente le réflecteur texturé obtenu avec le masque 3 composé de billes 4 de 1000nm de diamètre afin d'obtenir le réflecteur texturé représenté sur la figure 7.
Finalement, chaque réflecteur texturé est recouvert par les autres composants de la cellule photovoltaïque.

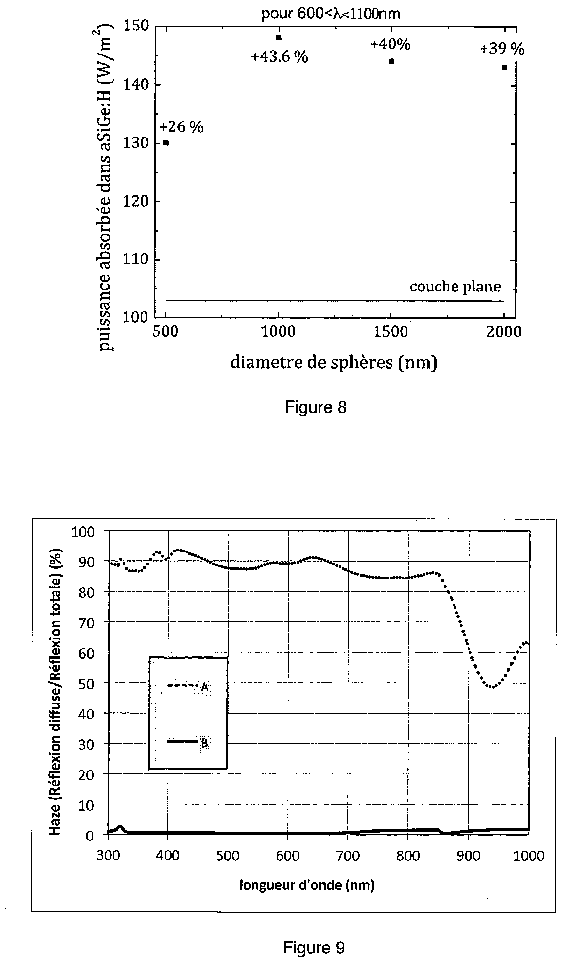

Le calcul de puissance absorbée pour une gamme de longueur d'onde comprise entre 600nm et 1100nm dans chacune des cellules photovoltaïques a ensuite été réalisé. Ainsi, les puissances des cellules photovoltaïques avec un réflecteur texturé, obtenu à partir des différents diamètres moyens de billes 4, ont été comparées à la puissance d'une même cellule photovoltaïque mais avec un réflecteur non texturé. Le réflecteur non texturé est une couche plane en argent, ladite couche en argent étant déposée par pulvérisation cathodique magnétron et faisant 300nm d'épaisseur.
Il a été constaté que l'augmentation de la puissance absorbée calculée par simulation optique dépend du diamètre des billes. Ces différentes puissances, dépendant du diamètre des billes 4 du masque 3, sont représentées à la figure 8.
Il a été constaté que l'augmentation de la puissance, pour un réflecteur texturé par rapport à un réflecteur non texturé, est maximale pour une texturation élaborée à partir de billes 4 dont le diamètre moyen est de 1µm : un gain de 43,6% est obtenu.

Le facteur de Haze d'un réflecteur texturé a aussi été mesuré. Le facteur de Haze représente le rapport entre le coefficient de réflexion diffuse et le coefficient de réflexion totale. La réflexion diffuse est notamment due à la texturation du réflecteur. Ainsi, sur la figure 9, l'évolution du facteur de Haze est représentée en fonction des longueurs d'onde du rayonnement électromagnétique incident, pour un réflecteur texturé et pour un réflecteur non texturé. Le réflecteur texturé présente des propriétés optiques améliorées. En effet, le facteur de Haze a augmenté significativement pour toutes les longueurs d'onde, et plus particulièrement, il a augmenté de plus de 80% pour les longueurs d'onde comprises entre 300nm et 850nm.
La présence du réflecteur texturé engendre donc un piégeage optique, ce qui permettra d'augmenter le rendement de conversion de la cellule photovoltaïque en couches minces déposée sur de tels réflecteurs. Ainsi, la réponse spectrale des cellules photovoltaïques, représentant le taux de génération de paires électrons-trous au sein de la cellule sera amélioré.

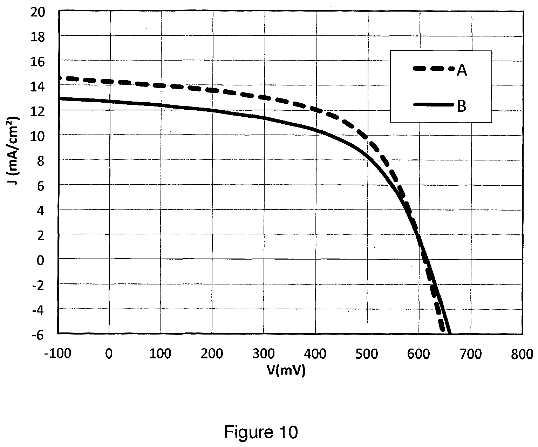

L'augmentation du rendement quantique externe se traduit par une augmentation de la densité de courant de court-circuit (Jsc). Le courant de court-circuit pour la cellule photovoltaïque ayant un réflecteur texturé obtenu à partir du masque ayant des billes de 1µm (courbe A sur la figure 10) a donc été comparé à celui d'une cellule photovoltaïque sans réflecteur texturé (courbe B sur la figure 10). La densité de courant de court-circuit (Jsc) est représentée en fonction de la tension de circuit ouvert (V). Un gain de 10% est obtenu pour la cellule photovoltaïque avec le réflecteur texturé, correspondant à un gain de 15% en terme de rendement.

Par ailleurs, la détermination de caractéristiques Jsc, Voc, FF et Eff de 32 cellules photovoltaïques références, ayant un réflecteur plan, et de 32 cellules photovoltaïques, ayant un même réflecteur mais texturé, a été réalisée sous un éclairement normalisé AM1.5, c'est-à-dire correspondant à un rayon de soleil traversant 1,5 fois la masse atmosphérique, le soleil étant au zénith. Toutes les cellules sont des cellules photovoltaïques aSiGe :H. Les résultats sont donnés dans le tableau ci-dessous. Les cellules photovoltaïques références sont appelées « cellules non texturées » et les cellules photovoltaïques ayant un réflecteur texturé sont appelées « cellules texturées ». Jsc correspond au courant de court-circuit, Voc correspond à la tension de circuit ouvert, FF correspond au facteur de forme de la cellule photovoltaïque et Eff est l'abréviation de l'Efficacité Quantique Externe (EQE). L'EQE correspond au rapport du nombre de charges électroniques collectées sur le nombre de photons incidents. Les résultats obtenus sont représentés dans le tableau ci-dessous.

| | | Jsc (mA/cm2) | Voc (mV) | FF (%) | Eff (%) | Nombre de cellules fonctionnelles |
|---|---|---|---|---|---|---|
| Cellules non texturées | Maximum | 14,4 | 619 | 56 | 4,70 | 19/32 (59%) |
| | Minimum | 12,3 | 592 | 51 | 3,77 | |
| | Moyenne | 12,8 | 615 | 54 | 4,28 | |
| Cellules texturées | Maximum | 14,4 | 614 | 58 | 5,04 | 23/32 (72%) |
| | Minimum | 13,8 | 609 | 54 | 4,62 | |
| | Moyenne | 14,1 | 612 | 57 | 4,90 | |

Les cellules photovoltaïques ayant un réflecteur texturé présentent donc des performances améliorées par rapport aux cellules photovoltaïques ayant un réflecteur plan.

La portée de cette invention est d'autant plus grande dans le domaine des cellules photovoltaïques qu'elle peut être utilisée pour le développement des cellules photovoltaïques en couches minces telles que des cellules de type silicium amorphe hydrogéné a-Si :H, des cellules de type silicium-germanium amorphe hydrogéné a-SiGe :H, des cellules en silicium microcristallin hydrogéné µc-Si :H, des cellules tandem, des cellules multi-jonctions. En effet, le procédé de texturation peut être adapté à n'importe quel type de cellule photovoltaïque en couches minces, car il peut s'ajuster à la gamme d'absorption de cette dernière.

Ce type de réflecteur texturé permet non seulement d'améliorer le rendement des cellules en augmentant le piégeage optique, mais aussi de diminuer l'épaisseur de la couche absorbante tout en conservant le même rendement cellule. Pour certaines cellules photovoltaïques, par exemple, pour une cellule en µc-Si: H, l'épaisseur de la couche active étant critique, une diminution de l'épaisseur de la couche absorbante est un enjeu important.

Le procédé de réalisation permet, de plus, d'être appliqué à de grandes surfaces et à n'importe quel type de support.

## Revendications

1. Procédé de réalisation d'un réflecteur texturé pour une cellule photovoltaïques en couches minces comprenant les étapes suivantes :
- déposer un film métallique (1) sur un support (2), à travers les ouvertures d'un masque (3), le masque (3) étant formé par une couche mince constituée de billes (4) coplanaires, les interstices (5) entre les billes (4) formant les ouvertures du masque (3), de manière à former un film métallique (1) présentant une surface texturée,
- retirer le masque (3) après le dépôt du film métallique (1) sur le support (2),
- réaliser le dépôt uniforme d'un film métallique additionnel (8) sur le film métallique (1), après le retrait du masque (3), de manière à former un film métallique additionnel (8) **caractérisé en ce que** le film métallique additionnel (8) reproduit la surface texturée du film métallique (1).

2. Procédé selon la revendication 1, **caractérisé en ce que** les billes (4) constituant la couche mince sont jointives.

3. Procédé selon l'une quelconque des revendications 1 à 2, **caractérisé en ce que** les billes (4) sont en silice ou en matériau polymère.

4. Procédé selon l'une quelconque des revendications 1 à 3, **caractérisé en ce que** la couche mince constituée des billes (4) présente une compacité comprise entre 80% et 94%.

5. Procédé selon l'une quelconque des revendications 1 à 4, **caractérisé en ce que** les billes (4) constituant la couche mince sont monodisperses et leur diamètre moyen est compris entre 100nm et 5000nm et de préférence entre 500nm et 2500nm.

6. Procédé selon l'une quelconque des revendications 1 à 5, **caractérisé en ce que** le dépôt du film métallique (1) est réalisé par pulvérisation cathodique magnétron ou par évaporation sous vide.

7. Procédé selon l'une quelconque des revendications 1 à 6, **caractérisé en ce que** l'épaisseur (7) du film métallique (1) est comprise entre 150nm et 750nm.

8. Procédé selon l'une quelconque des revendications 1 à 7, **caractérisé en ce que** le film métallique (1) est un constitué par un métal choisi parmi le groupe constitué par l'aluminium, le chrome, l'argent et le cuivre ou par un de leurs alliages.

9. Procédé selon l'une quelconque des revendications 1 à 8, **caractérisé en ce que** le masque (3) est formé sur le support par dépôt à la tournette ou par la méthode de Langmuir-Blodgett.

10. Procédé selon l'une quelconque des revendications 1 à 9, **caractérisé en ce que** la formation du masque (3) comporte une étape de gravure des billes (4) préalablement formées sur le support (2), afin de réduire leur diamètre moyen.

11. Procédé selon l'une quelconque des revendications 1 à 10, **caractérisé en ce que** le film additionnel (8) est déposé par dépôt physique en phase vapeur ou par dépôt chimique en phase vapeur.

12. Procédé selon l'une quelconque des revendications 1 à 11, **caractérisé en ce que** le film métallique additionnel (8) a une épaisseur comprise entre 50nm et 1500nm et, de préférence, entre 100nm et 500nm.

13. Procédé selon l'une quelconque des revendications 1 à 12, **caractérisé en ce que** le film métallique additionnel (8) est constitué par un métal choisi parmi le groupe constitué par l'argent, l'aluminium, le cuivre, le chrome et le titane ou par un de leurs alliages.

14. Procédé selon l'une quelconque des revendications 1 à 13, **caractérisé en ce que** le film métallique (1) et le film métallique additionnel (8) sont respectivement en aluminium et en argent.

15. Procédé selon l'une quelconque des revendications 1 à 14, **caractérisé en ce que** le support (2) est en métal.

16. Réflecteur texturé pour une cellule photovoltaïque en couches minces obtenu par un procédé de réalisation selon l'une quelconque des revendications 1 à 15.

## Patentansprüche

1. Verfahren zur Herstellung eines strukturierten Reflektors für eine Dünnschichtfotozelle, das folgende Verfahrensschritte umfasst:
- Auftragen eines Metallfilms (1) auf einen Träger (2) durch die Öffnungen einer Maske (3), wobei die Maske (3) von einer dünnen Schicht gebildet wird, die sich aus in einer Ebene liegenden Kugeln (4) zusammensetzt, wobei die Zwischenräume (5) zwischen den Kugeln (4) die Öffnungen der Maske (3) bilden, so dass ein Metallfilm (1) entsteht, der eine strukturierte Oberfläche aufweist,
- Entfernen der Maske (3) nach dem Auftragen des Metallfilms (1) auf den Träger (2),
- Durchführen einer gleichmäßigen Beschichtung mit einem zusätzlichen Metallfilm (8) auf dem Metallfilm (1), und zwar nach dem Entfernen der Maske (3), so dass ein zusätzlicher Metallfilm (8) gebildet wird,
**dadurch gekennzeichnet,**
**dass** der zusätzliche Metallfilm (8) die strukturierte Oberfläche des Metallfilms (1) wiedergibt.

2. Verfahren nach Anspruch 1,
**dadurch gekennzeichnet,**
**dass** die Kugeln (4), die die dünne Schicht bilden, aneinanderstoßend angeordnet sind.

3. Verfahren nach einem der Ansprüche 1 bis 2,
**dadurch gekennzeichnet,**
**dass** die Kugeln (4) aus Siliziumoxid oder aus einem Polymer bestehen.

4. Verfahren nach einem der Ansprüche 1 bis 3,
**dadurch gekennzeichnet,**
**dass** die von den Kugeln (4) gebildete dünne Schicht eine Dichte von 80% bis 94% aufweist.

5. Verfahren nach einem der Ansprüche 1 bis 4,
**dadurch gekennzeichnet,**
**dass** die Kugeln (4), die die dünne Schicht bilden, einfachdispergiert sind und ihr Durchmesser durchschnittlich zwischen 100nm und 5000nm, und vorzugsweise zwischen 500nm und 2500nm beträgt.

6. Verfahren nach einem der Ansprüche 1 bis 5,
**dadurch gekennzeichnet,**
**dass** das Auftragen des Metallfilms (1) durch Magnetron-Kathodenzerstäubung oder durch Aufdampfen unter Vakuum erfolgt.

7. Verfahren nach einem der Ansprüche 1 bis 6,
**dadurch gekennzeichnet,**
**dass** die Stärke (7) des Metallfilms (1) zwischen 150nm und 750nm beträgt.

8. Verfahren nach einem der Ansprüche 1 bis 7,
**dadurch gekennzeichnet,**
**dass** der Metallfilm (1) aus einem Metall besteht, das unter Aluminium, Chrom, Silber und Kupfer oder einer von deren Legierungen gewählt ist.

9. Verfahren nach einem der Ansprüche 1 bis 8,
**dadurch gekennzeichnet,**
**dass** die Maske (3) auf dem Träger durch Auftragen mit dem Schleuderapparat oder mit dem Langmuir-Blodgett-Verfahren gebildet wird.

10. Verfahren nach einem der Ansprüche 1 bis 9,
**dadurch gekennzeichnet,**
**dass** die Herstellung der Maske (3) einen Schritt des Gravierens der zuvor auf dem Träger (2) gebildeten Kugeln (4) umfasst, um ihren durchschnittlichen Durchmesser zu verringern.

11. Verfahren nach einem der Ansprüche 1 bis 10,
**dadurch gekennzeichnet,**
**dass** der zusätzliche Film (8) durch PVD-Verfahren oder durch Gasphasenabscheidung aufgebracht wird.

12. Verfahren nach einem der Ansprüche 1 bis 11,
**dadurch gekennzeichnet,**
**dass** der zusätzliche Metallfilm (8) eine Stärke hat, die 50nm bis 1500nm, und vorzugsweise 100nm bis 500nm beträgt.

13. Verfahren nach einem der Ansprüche 1 bis 12,
**dadurch gekennzeichnet,**
**dass** der zusätzliche Metallfilm (8) aus einem Metall gebildet ist, das unter Silber, Aluminium, Kupfer, Chrom und Titan oder einer von deren Legierungen gewählt ist.

14. Verfahren nach einem der Ansprüche 1 bis 13,
**dadurch gekennzeichnet,**
**dass** der Metallfilm (1) und der zusätzliche Metallfilm (8) aus Aluminium bzw. aus Silber bestehen.

15. Verfahren nach einem der Ansprüche 1 bis 14,
**dadurch gekennzeichnet,**
**dass** der Träger (2) aus Metall besteht.

16. Strukturierter Reflektor für eine Dünnschichtfotozelle, der durch ein Herstellungsverfahren nach einem der Ansprüche 1 bis 15 hergestellt ist.

## Claims

1. A method for producing a textured reflector for a thin film solar cell comprising the following steps:
- depositing a metal film (1) on a support (2), through openings of a mask (3), the mask (3) being formed by a thin film formed by coplanar balls (4), the gaps (5) between the balls (4) forming the openings of the mask (3) so as to form a metal film (1) presenting a textured surface,
- removing the mask after depositing the metal film (1) on the support (2),
- depositing uniformly an additional metal film (8) on the metal film (1), after the mask (3) has been removed so as to form an additional metal film (8)
**characterized in that** the additional metal film (8) replicates the textured surface of the metal film (1).

2. The method according to claim 1, **characterized in that** the balls (4) forming the thin film are joined.

3. The method according to any one of claims 1 to 2, **characterized in that** the balls (4) are made from silica or from polymer material.

4. The method according to any one of claims 1 to 3, **characterized in that** the thin film formed by the balls (4) presents a compactness comprised between 80% and 94%.

5. The method according to any one of claims 1 to 4, **characterized in that** the balls (4) forming the thin film are monodispersed and their mean diameter is comprised between 100nm and 5000nm, and preferably between 500nm and 2500nm.

6. The method according to any one of claims 1 to 5, **characterized in that** deposition of the metal film (1) is performed by magnetron cathode sputtering or by vacuum evaporation.

7. The method according to any one of claims 1 to 6, **characterized in that** the thickness (7) of the metal film (1) is comprised between 150nm and 750nm.

8. The method according to any one of claims 1 to 7, **characterized in that** the metal film (1) is formed by a metal chosen from the group constituted by aluminium, chromium, silver and copper or by one of their alloys.

9. The method according to any one of claims 1 to 8, **characterized in that** the mask (3) is formed on the support by spin-coating or by the Langmuir-Blodgett method.

10. The method according to any one of claims 1 to 9, **characterized in that** formation of the mask (3) comprises an etching step of the balls (4) previously formed on the support (2) in order to reduce their mean diameter.

11. The method according to any one of claims 1 to 10, **characterized in that** the additional film (8) is deposited by physical vapor deposition or by chemical vapor deposition.

12. The method according to any one of claims 1 to 11, **characterized in that** the additional metal film (8) has a thickness comprised between 50nm and 1500nm and preferably between 100nm and 500nm.

13. The method according to any one of claims 1 to 12, **characterized in that** the additional metal film (8) is formed by a metal chosen from the group constituted by silver, aluminium, copper, chromium and titanium or by one of their alloys.

14. The method according to any one of claims 1 to 13, **characterized in that** the metal film (1) and the additional metal film (8) are respectively made from aluminium and from silver.

15. The method according to any one of claims 1 to 14, **characterized in that** the support (2) is made from metal.

16. A textured reflector for a thin film solar cell obtained by a production method according to any one of claims 1 to 15.
